# EUROPÄISCHE PATENTSCHRIFT

(11) **EP 2 275 826 B1**
(45) Veröffentlichungstag und Bekanntmachung des Hinweises auf die Patenterteilung: **27.06.2018**
(21) Anmeldenummer: 10007125.7
(22) Anmeldetag: 09.07.2010
(51) Int. Cl.: G01R 15/18

(54) **Stromwandler für einen elektronischen Elektrizitätszähler**
Electricity converter for an electronic electricity meter
Convertisseur de courant pour un compteur d'électricité électronique

(30) Priorität: 15.07.2009 DE 102009033126
(43) Veröffentlichungstag der Anmeldung: 19.01.2011
(73) Patentinhaber: EMH metering GmbH & Co. KG, 19258 Gallin (DE)
(72) Erfinder: Malek, Norbert, 21438 Brackel (DE)
(74) Vertreter: Hauck Patentanwaltspartnerschaft mbB

(56) Entgegenhaltungen:
- EP-A2- 0 718 635
- EP-A2- 0 848 395
- EP-A2- 1 028 321
- FR-A1- 2 619 925
- JP-A- 2002 202 328
- US-A- 4 240 059
- US-A- 4 492 919
- US-A- 4 939 451

## Beschreibung

Die Erfindung bezieht sich auf einen Stromwandler für einen elektronischen Elektrizitätszähler nach dem Anspruch 1.

Aus EP 1 460 438 A1 ist ein Elektrizitätszähler bekannt geworden, bei dem ein Zählermodul über eine Steckverbindung mit einem Wandlermodul verbindbar ist. Wird das Zählermodul entfernt, sorgen die gleichstromfesten Wandler dafür, dass keine Störung auftritt.

Es ist ferner bekannt, Wandler für elektronische Elektrizitätszähler so auszuführen, dass durch die Primärspule des Wandlers nur ein Bruchteil des Stroms fließt, der vom Versorger zum Verbraucher strömen kann, je nach Leistung des eingeschalteten Verbrauchers. Derartige Stromteiler bestehen entweder aus einer Parallelschaltung von Stromzweigen, wobei der Strom nur in einem Stromzweig gemessen wird oder aus einer Wheatstoneschen Brücke, bei der die Sekundärwicklung dem Diagonalzweig zugeordnet ist. Zur ersteren Kategorie gehören Stromwandler, wie sie aus US 4,182,982 oder US 4,492,919 bekannt geworden sind. Zur zweiten Kategorie gehören Stromwandler, wie sie aus US 4,240,059 bekannt geworden sind. Aus diesen Dokumenten ist auch bekannt, die einzelnen Zweige des Stromteilers aus gleichem Material zu fertigen. Aus EP 0 670 498 A1 ist auch bekannt, für Brückenzweige einer Wheatstoneschen Brücke als Spannungsteiler einstellbare Widerstände zu verwenden, um eine Feinjustierung vornehmen zu können. Nachteilig ist hierbei, dass diese Widerstände aus einem anderen Material als die übrigen Widerstände bestehen, wodurch es bei Temperaturänderungen zu einer Veränderung der Widerstandverhältnisse kommt und somit zu Fehlern in der Messung durch den Elektrizitätszähler.

Aus US 4,240,059 ist auch bekannt geworden, für den Stromteiler ein Blechstanzteil vorzusehen in dem ein Kreisring, an den diametral Anschlüsse für den Stromzufluss und den Stromabfluss angebracht sind, durch einen Durchmesserzweig so unterteilt ist, dass der Strom zum einen Ende des Durchmesserzweiges einen größeren Weg zurücklegt als zum anderen Ende.

Aus dem US Patent Nr. 4,939,451 ist ein Stromwandler mit einem Stromteiler in Form einer Wheatstone'schen Brücke, die einen Brückenzweig und einen Diagonalzweig aufweist, bekannt geworden, wobei ein Ringkern mit einer Sekundärwicklung des Stromwandlers den Diagonalzweig umgibt.

Der Erfindung liegt die Aufgabe zugrunde, einen Stromwandler für einen Elektrizitätszähler mit einem Stromteiler zu schaffen, der einfach aufgebaut ist, eine präzise Vorgabe der Widerstandswerte ermöglicht, eine einfache Montage der Sekundärwicklung erlaubt und insgesamt eine raumsparende Ausbildung verwirklicht.

Diese Aufgabe wird durch die Merkmale des Anspruchs 1 gelöst.

Bei dem erfindungsgemäßen Stromwandler weisen die Brückabschnitte des Stanzteils deutlich unterschiedliche Breiten auf, und ein separater Diagonalzweig ist aus dem gleichen Material wie das Stanzteil gefertigt und mit seinen Enden mit Verbindungsstellen eines breiten Abschnitts und eines schmalen Abschnitts verschweißt, insbesondere mit den breiteren Abschnitten.

Durch die erfindungsgemäße Ausbildung des Stanzteils lassen sich geometrisch präzise Widerstandswerte für einen Stromteiler nach der Wheatstoneschen Brücke vorgeben, wobei der separate Diagonalzweig aufgrund des gleichen Materials wie dem des Stanzteils eine thermische "Verstimmung" des Stromteilers verhindert. Der separate Diagonalzweig, der ebenfalls als Stanzteil geformt sein kann, ermöglicht eine einfache Montage des Ringkernes mit Sekundärwicklung und gegebenenfalls einer Kompensationswicklung, bevor er verschweißt wird. Die Montage des erfindungsgemäßen Stromwandlers lässt sich daher in einfacher Weise verwirklichen, gegebenenfalls auf vollständig automatischem Wege.

Nach einer Ausgestaltung der Erfindung weist das Stanzteil einen rechteckigen Rahmen auf, vorzugsweise einen quadratischen Rahmen, bei dem erste gegenüberliegende Seiten von schmalen und breiten Abschnitten gebildet sind und zweite gegenüberliegende Seiten von schmalen Abschnitten. Vorzugsweise sind die Anschlüsse mit Verlängerungen der breiten Brückenabschnitte verbunden.

Um eine besonders platzsparende Ausbildung eines derartigen Stromteilers zu erzielen, sieht eine weitere Ausgestaltung der Erfindung vor, dass die ersten Seiten des Rahmens um die Enden der zweiten Seiten zu einem kastenförmigen oder U-förmigen Profil gebogen sind. Die Abmessungen eines derartigen Stromteilers sind daher minimal. Der Stromteiler bildet auch eine ausreichende stabile Konstruktion zur Aufnahme und Lagerung des Ringkerns mit Sekundär- und gegebenenfalls Kompensationswicklung für den Stromwandler.

Für einige Anwendungsfälle kann es vorteilhaft sein, wenn ein Anschlussabschnitt an einem Ende des Rahmens unterhalb des U-Profils zum anderen Anschlussabschnitt zurückgebogen ist.

Um das beschriebene Widerstandsnetzwerk langzeitstabil zu halten, ist es nach einer weiteren Ausgestaltung der Erfindung vorteilhaft, wenn die Oberfläche des Stanzteils und des Diagonalzweigs mit einer oxidationsverhindernden Oberfläche versehen ist. Dies kann z. B. durch Verzinnung, Lackierung, Passivierung usw. erzielt werden.

Ausführungsbeispiele der Erfindung werden nachfolgend anhand von Zeichnungen näher erläutert.
- Fig. 1: zeigt perspektivisch einen Stromwandler nach der Erfindung.
- Fig. 2: zeigt perspektivisch einen Stromteiler für den Stromwandler nach Fig. 1 ohne Primär- und Sekundärwicklung.
- Fig. 3: zeigt ein Stanzteil für den Stromteiler nach Fig. 2.
- Fig. 4: zeigt das Stanzteil nach Fig. 3 mit einem Brücken-Diagonalzweig als Primärwicklung.
- Fig. 5: zeigt perspektivisch eine Alternative zum Stromteiler nach Fig. 2.

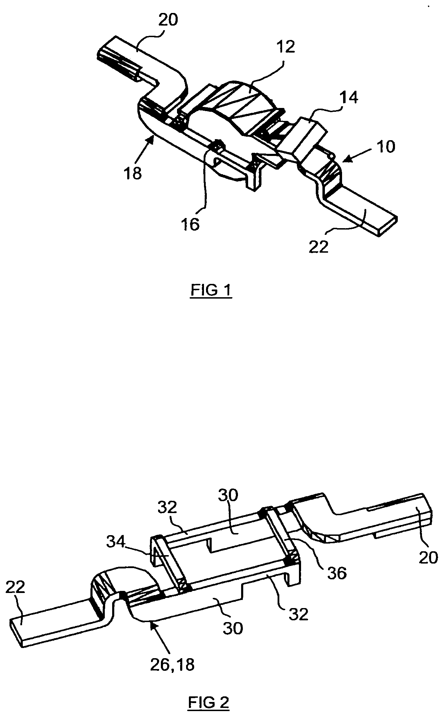

In Fig. 1 ist ein Stromwandler 10 dargestellt, der einen Ringkern mit Wickelpaket 12 aufweist mit Sekundär- und Kompensationswicklung, welche mit einem Steckerteil 14 verbunden sind. Die Primärwicklung wird von einem Draht 16 oder einem Stanzteil gebildet, das mit einem Stromteiler 18 verschweißt wird, wie dies noch weiter unten erläutert wird. Ein Anschlussabschnitt 20 ist einteilig mit dem Stromteiler 18 geformt, wie auch ein weiterer Anschlussabschnitt 22 am gegenüberliegenden Ende. Die Anschlussabschnitte 20, 22 werden mit der Versorgerleitung bzw. der Verbraucherleitung verbunden. Es versteht sich, dass für einen Dreiphasenzähler drei Stromwandler gemäß Fig. 1 erforderlich sind. Sie sind üblicherweise nebeneinander angeordnet, entweder in einem Zählergehäuse oder auf einer Aufnahmeplattform für ein Zählermodul (nicht gezeigt).

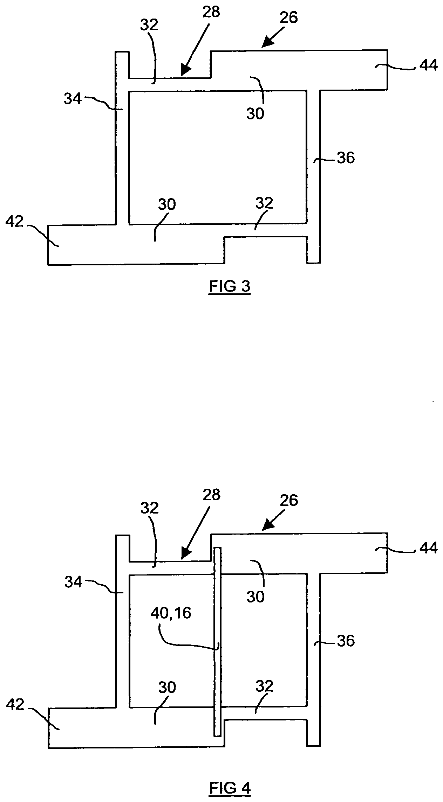

Der Aufbau des Spannungsteilers geht näher aus den Fig. 2 bis 4 hervor. Aus einem geeigneten Flachmaterial wird ein rahmenförmiges Stanzteil 26 ausgestanzt. Es besitzt einen rechteckigen Rahmen 28, wobei erste gegenüberliegende Seiten in Reihe einen breiten Abschnitt 30 und einen schmalen Abschnitt 32 aufweisen. Die anderen gegenüberliegenden Seiten werden von schmalen Abschnitten 34, 36 gebildet. Sie haben die gleiche Breite wie die Abschnitte 32. Die Abschnitte 32, 34 bzw. 32, 36 bilden gleichgroße Widerstände, da sie gleiche Länge bei gleichem Querschnitt haben. Die Abschnitte 30 bilden zweite gleichgroße Widerstände von einem anderen Widerstandswert. Die Abschnitte 30, 32, 34, 36 bilden Brückenzweige einer Wheatstoneschen Brücke, welche durch einen Diagonalzweig 40 vervollständigt ist. Dies ist in Fig. 4 dargestellt. Der Diagonalzweig 40 entspricht dem Diagonalzweig 16 des Stromwandlers nach Fig. 1. Der Diagonalzweig 40 kann ebenfalls als Stanzteil oder als Draht geformt sein und ist mit den Enden auf den beiden Verbindungsstellen des breiten Abschnitts 30 und des schmalen Abschnitts 32 aufgeschweißt. Er bildet die Primärseite des Stromwandlers nach Fig. 1. Der diagonale Brückenzweig 40 ist aus dem gleichen Material wie das Stanzteil 26 geformt. Die Oberfläche aller Teile des Stromteilers nach Fig. 4 ist durch eine geeignete Behandlung gegen Oxidation geschützt, damit der Stromwandler Langzeitstabilität erhält.

In Fig. 3 und 4 sind Anschlussabschnitte 42, 44 in Verlängerung der breiteren Brückenabschnitte 30 gebildet. Die geometrische Formgebung ist jedoch für die erwünschte Stromteilung nicht relevant.

In Fig. 2 ist dargestellt, wie etwa ein Stanzteil nach Fig. 3 umgeformt wird zum Einbau in einen geeigneten Elektrizitätszähler. Die Seiten des Rahmens 28 nach Fig. 3, welche die schmalen und breiten Brückabschnitte 30, 32 enthalten, sind um die anderen Seiten 34, 36 zu einem U-förmigen oder Kastenprofil gebogen. Der Anschlussabschnitt 20, der zunächst in der Ebene der einen Seite mit den Abschnitten 30, 32 verläuft, wird in die Ebene der Abschnitte 34, 36 umgebogen, und der Anschlussabschnitt 22 wird aus der Ebene der Abschnitte 30, 32 der anderen Seite durch eine doppelte Biegung parallel zur Ebene des Anschlussabschnitts 20 gebogen. Im Prinzip ist jedoch diese Formgebung für die Erfindung unwichtig und lediglich zur Anpassung an die Einbausituation im Zähler gedacht.

Der Wickelkörper 12 nach Fig. 1 wird anschließend in das gezeigte Profil nach Fig. 2 eingesetzt, und der Draht 16 bzw. der Diagonalabschnitt 40 wird durch den Wickelkörper 12 hindurch gesteckt und in geeigneter Weise mit den schmalen Seiten an den beiden Verbindungsstellen des breiten Abschnitts 30 und des schmalen Abschnitts 32 verschweißt. Damit ist der Stromwandler fertig und kann mit weiteren Stromwandlern in den nicht gezeigten Elektrizitätszähler eingebaut werden.

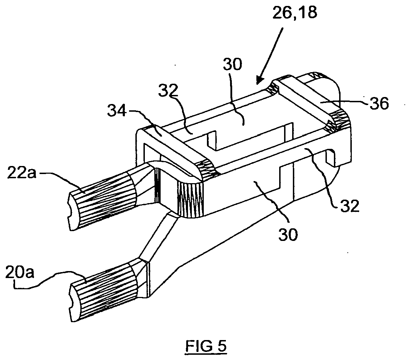

Bei der Ausführungsform nach Fig. 5 wird ein abgewandeltes Stromteilerprofil verwendet. Unterschiedlich zu Fig. 2 bzw. Fig. 1 ist, dass ein Anschluss 20a am in Fig. 5 rechten Ende des Stromteilerrahmens unterhalb von diesem zurückgebogen wird parallel zum und unterhalb vom Anschluss 22a. Hiermit werden andere Einbauumstände berücksichtigt als bei der Ausführungsform nach den Fig. 1 und 2.

## Patentansprüche

1. Stromwandler (10) für einen elektronischen Elektrizitätszähler mit einem Stromteiler (18), wobei der Stromteiler (18) nicht aus einer Parallelschaltung von Stromzweigen, bei der der Strom nur in einem Stromzweig gemessen wird, besteht, sondern die Form einer Wheatstoneschen Brücke hat, die Brückenzweige und einen Diagonalzweig (40, 16) aufweist, wobei die Widerstände der Brückenzweige von Abschnitten (30, 32, 34, 36) eines Stanzteils (26) aus Flachmaterial gebildet sind und ein Ringkern mit einer Sekundärwicklung des Stromwandlers (10) den Diagonalzweig (40, 16) umgibt, wobei sich die Größen der Widerstände aus den Längen und Querschnitten der Abschnitte (30, 32, 34, 36) ergeben, **dadurch gekennzeichnet, dass** die Brückenzweige jeweils einen breiten Abschnitt (30) und einen schmalen Abschnitt (32) aufweisen und der Diagonalzweig (40, 16) ein separater Diagonalzweig (40, 16) aus dem gleichen Material wie das Stanzteil (26) ist, dessen Enden jeweils mit einer Verbindungsstelle eines der breiten Abschnitte (30) und eines der schmalen Abschnitte (32) verschweißt sind.

2. Stromwandler (10) nach Anspruch 1, **dadurch gekennzeichnet, dass** das Stanzteil (26) einen rechteckigen Rahmen (28) aufweist, bei dem erste gegenüberliegende Seiten von den schmalen Abschnitten (32) und den breiten Abschnitten (30) und zweite gegenüberliegende Seiten von weiteren schmalen Abschnitten (34, 36) der Brückenzweige gebildet sind.

3. Stromwandler (10) nach Anspruch 2, **dadurch gekennzeichnet, dass** Stromanschlüsse von Verlängerungsabschnitten (42, 44) der breiten Abschnitte (30) gebildet sind.

4. Stromwandler (10) nach Anspruch 3, **dadurch gekennzeichnet, dass** die Verlängerungsabschnitte (42, 44) die gleiche Breite wie die breiten Abschnitte (30) aufweisen.

5. Stromwandler (10) nach Anspruch 2 und 3, **dadurch gekennzeichnet, dass** die ersten gegenüberliegenden Seiten des Rahmens (28) um die Enden der zweiten gegenüberliegenden Seiten (34, 36) zu einem kastenförmigen oder U-förmigen Profil gebogen sind.

6. Stromwandler (10) nach Anspruch 5, **dadurch gekennzeichnet, dass** ein zweiter Anschlussabschnitt (20a) an einem Ende des Rahmens (28) unterhalb des Rahmens (28) zu einem ersten Anschlussabschnitt (22a) zurückgebogen ist.

7. Stromwandler (10) nach einem der Ansprüche 1 bis 6, **dadurch gekennzeichnet, dass** die Oberflächen des Stanzteils (26) und des Diagonalzweigs (40, 16) mit einer eine Oxidation verhindernden Behandlung oder Beschichtung versehen sind.

## Claims

1. A current transformer (10) for an electronic electricity meter with a current divider (18), wherein the current divider (18) is not composed of a parallel circuit of current branches in which the current is only measured in one current branch, but rather has the shape of a Wheatstone bridge that has bridge branches and a diagonal branch (40, 16), wherein the resistors of the bridge branches are formed from sections (30, 32, 34, 36) of a stamped part (26) made of flat material, and a ring core with a secondary winding of the current transformer (10) surrounds the diagonal branch (40, 16), wherein the values of the resistors result from the lengths and cross-sections of the sections (30, 32, 34, 36), **characterized in that** the bridge branches each have a wide section (30) and a narrow section (32) and the diagonal branch (40, 16) is a separate diagonal branch (40, 16) of the same material as the stamped part (26), the ends of which are welded to a connecting point of one of the wide sections (30) and one of the narrow sections (32) respectively.

2. The current transformer (10) according to claim 1, **characterized in that** the stamped part (26) has a rectangular frame (28) in which first opposite sides of the narrow sections (32) and the wide sections (30) and second opposite sides of further narrow sections (34, 36) of the bridge branches are formed.

3. The current transformer (1) according to claim 2, **characterized in that** current connections are formed from extension sections (42, 44) of the wide sections (30).

4. The current transformer (10) according to claim 3, **characterized in that** the extension sections (42, 44) have the same width as the wide sections (30).

5. The current transformer (10) according to claim 2 and 3, **characterized in that** the first opposite sides of the frame (28) are bent about the ends of the second opposite sides (34, 36) into a box-shaped or U-shaped profile.

6. The current transformer (10) according to claim 5, **characterized in that** a second connection section (20a) at one end of the frame (28) is bent back underneath the frame (28) to a first connection section (22a).

7. The current transformer (10) according to one of claims 1 to 6, **characterized in that** the surfaces of the stamped part (26) and of the diagonal branch (40, 16) are provided with a treatment or coating to prevent oxidation.

## Revendications

1. Convertisseur de courant (10) pour un compteur d'électricité électronique avec un diviseur de courant (18), dans lequel le diviseur de courant (18) n'est pas constitué d'un circuit parallèle de branches de courant, dans lequel le courant n'est mesuré que dans une branche de courant, mais présente la forme d'un pont de Wheatstone présentant des branches de pont et une branche diagonale (40, 16), dans lequel les résistances des branches de pont sont formées par des sections (30, 32, 34, 36) d'une pièce emboutie (26) en un matériau plat et un noyau annulaire avec un enroulement secondaire du convertisseur de courant (10) entoure la branche diagonale (40, 16), dans lequel les valeurs des résistances résultent des longueurs et des sections transversales des sections (30, 32, 34, 36), **caractérisé en ce que** les branches de pont présentent respectivement une section large (30) et une section étroite (32) et la branche diagonale (40, 16) est une branche diagonale (40, 16) séparée constituée du même matériau que la pièce emboutie (26), dont les extrémités sont respectivement soudées avec une zone d'assemblage de l'une des sections larges (30) et de l'une des sections étroites (32).

2. Convertisseur de courant (10) selon la revendication 1, **caractérisé en ce que** la pièce emboutie (26) présente un cadre rectangulaire (28), dans lequel sont formés des premiers côtés opposés des sections étroites (32) et des sections larges (30) et des deuxièmes côtés opposés d'autres sections étroites (34, 36) des branches de pont.

3. Convertisseur de courant (10) selon la revendication 2, **caractérisé en ce que** des raccordements électriques sont formés par des sections de prolongation (42, 44) des sections larges (30).

4. Convertisseur de courant (10) selon la revendication 3, **caractérisé en ce que** les sections de prolongation (42, 44) présentent la même largeur que les sections larges (30).

5. Convertisseur de courant (10) selon la revendication 2 et la revendication 3, **caractérisé en ce que** les premiers côtés opposés du cadre (28) sont courbés autour des extrémités des deuxièmes côtés opposés (34, 36) de manière à former un profil en forme de boîte ou en forme de U.

6. Convertisseur de courant (10) selon la revendication 5, **caractérisé en ce qu'**une deuxième section de raccordement (20a) est recourbée en dessous du cadre (28) vers une première section de raccordement (22a) à une extrémité du cadre (28).

7. Convertisseur de courant (10) selon l'une des revendications 1 à 6, **caractérisé en ce que** les surfaces supérieures de la pièce emboutie (26) et de la branche diagonale (40, 16) sont pourvues d'un traitement ou d'un revêtement empêchant l'oxydation.
